# EUROPÄISCHE PATENTANMELDUNG

(11) **EP 1 193 040 A1**
(43) Veröffentlichungstag der Anmeldung: **03.04.2002**
(21) Anmeldenummer: 01122172.8
(22) Anmeldetag: 15.09.2001
(51) Int. Cl.: B29C 45/16, H05K 3/18

(54) **Kunststoff-Spritzgussteil und Verwendung**

(30) Priorität: 29.09.2000 DE 10048768; 01.11.2000 DE 10054088
(71) Anmelder: W.C. Heraeus GmbH & Co. KG, 63450 Hanau (DE)
(72) Erfinder: Claus, Stefan, 63776 Mömbris (DE); Krüger, Frank, Dr., 61200 Wölfersheim (DE); Wahode, Jan, 63579 Freigericht (DE); Bittrich, Hans-Heiner, Dr., 40670 Meerbusch (DE); Zippmann, Volker, 35440 Linden (DE)
(74) Vertreter: Kühn, Hans-Christian

(57) **Zusammenfassung**

Die Erfindung betrifft ein Kunststoff-Spritzgussteil bestehend aus einer ersten thermoplastischen Komponente und einer zweiten thermoplastischen Komponente, wobei mindestens auf einer Oberfläche des Kunststoff-Spritzgussteils Bereiche aus der ersten thermoplastischen Komponente neben Bereichen aus der zweiten thermoplastischen Komponente angeordnet sind, und wobei die erste thermoplastische Komponente ein LCP ist und die zweite thermoplastische Komponente ein syndiotaktisches Polystyrol ist.

## Beschreibung

Die Erfindung betrifft ein Kunststoff-Spritzgussteil bestehend aus einer ersten thermoplastischen Komponente und einer zweiten thermoplastischen Komponente, wobei mindestens auf einer Oberfläche des Kunststoff-Spritzgussteils Bereiche aus der ersten thermoplastischen Komponente neben Bereichen aus der zweiten thermoplastischen Komponente angeordnet sind, und wobei die erste thermoplastische Komponente ein LCP ist. Außerdem betrifft die Erfindung eine Verwendung von syndiotaktischem Polystyrol.

OS DE 44 32 966 A1, die sich auch auf die DE 44 16 986 A1 bezieht, beschreibt ein Zweikomponenten-Spritzguss-Verfahren zur Herstellung gattungsgemäßer Kunststoff-Spritzgussteile und solche Bauteile. Bei dem Verfahren wird aus zwei thermoplastischen Kunststoff-Komponenten ein Formkörper gespritzt, dessen Oberfläche sich nach dem Spritzguss aus nebeneinander angeordneten Bereichen dieser Komponenten zusammensetzt. Dabei unterscheiden sich die verwendeten thermoplastischen Komponenten in ihrer Metallisierbarkeit. Als metallisierbare Komponente wird Polyamid der Gruppe PA6, PA6.6 oder PA6.6/6, Acrylnitril-Butadien-Styrol ABS, Polyoxymethylen POM, Liquid Cristal Polymer LCP, Polyetherminid PEI, Polyethersulfon PES, Polypropylen PP oder Polycarbonat PC verwendet, wobei dem Kunststoff Glasfasern zugesetzt sein können. Als nicht oder schwer metallisierbare Komponente sind insbesondere Polymere offenbart, die eine hohe Resistenz gegen chemische Vorbehandlung aufweisen. Hier werden Polyamid der Gruppe PA6, PA66, rußgefüllte PA-Typen, PA11, PA12, PPA oder PA-Typen mit einem Füllstoffgehalt von > 50% verwendet. Das Bauteil wird nach dem Spritzguss einer chemischen Vorbehandlung unterzogen, die die beiden verwendeten Komponenten an der Oberfläche des Bauteils unterschiedlich stark angreift oder verändert. Durch die Verwendung der unterschiedlichen Kunststoff-Komponenten wird so eine unterschiedliche Aufrauhung oder Oberflächenstruktur erzeugt. Dabei ist eine stärkere Aufrauhung oder Veränderung der Oberfläche der metallisierbaren Komponente erwünscht, um die Haftung einer Metallschicht beim anschließenden Metallisieren zu verbessern beziehungsweise zu erhöhen. Die Bildung zumindest eines Teils der Dicke einer Metallschicht erfolgt dabei durch reines chemisches Abscheiden in einem Tauchbad.

Desweiteren ist aus dem Artikel "LCP selektiv metallisieren" ( Zeitschrift MO, Carl Hanser Verlag, München, Jahrg. 53, (1999) 3, Seiten 20 bis 22 ) die Metallisierung von LCP ( liquid crystalline polymer beziehungsweise flüssigkristallines Polymer ) für MID-Bauteile ( mouldedinterconnect-devices beziehungsweise dreidimensionale spritzgegossene Schaltungsträger ) bekannt. Dabei werden unterschiedliche Herstellungsverfahren für MID-Bauteile beschrieben, die aus zwei Kunststofftypen, kombiniert in einem Bauteil, gebildet werden. Einer der beiden Kunststofftypen ist metallisierbar. Außerdem ist ein LCP-Typ mit einer erhöhten Selektivität bei einer Metallisierung von Zweikomponenten-Spritzteilen offenbart, der neben einer Mineralfüllung von ca. 40 % etwa 50ppm bis 100ppm Palladium als Katalysator für die außenstromlose Metallisierung enthält. Für eine Metallisierung wird der Palladium-haltige LCP-Typ alkalisch angeätzt und auf die so vorbereitete Oberfläche Kupfer chemisch abgeschieden, das anschließend mit weiteren Schichten belegt wird.

Es stellt sich das Problem, ein Kunststoff-Spritzgussteil aus einer ersten und einer zweiten thermoplastischen Komponente herzustellen, wobei eine der Komponenten mit hoher Selektivität in einem Metallisierungsvorgang beschichtbar sein soll.

Das Problem wird dadurch gelöst, dass die zweite thermoplastische Komponente ein syndiotaktisches Polystyrol (sPS) ist.

Besonders vorteilhaft ist es für die Verbindung zwischen LCP und sPS, dass diese beim Spritzguss sehr ähnliche physikalische Eigenschaften bezüglich der Verarbeitbarkeit und der Schrumpfung beim Abkühlen aufweisen. So ist eine feste Verbindung mit gutem Kontakt zwischen den Komponenten erreichbar. Die chemischen Eigenschaften von LCP und sPS unterscheiden sich jedoch vorteilhafterweise. Während LCP beispielsweise in alkalischen Lösungen chemisch leicht angreifbar und anschließend gut metallisierbar ist, ist sPS in alkalischen Lösungen kaum angreifbar. Dabei ist auch faserverstärktes sPS, beispielsweise ein glasfaserverstärktes, verwendbar.

Ein besonderer Vorteil des erfindungsgemäßen Kunststoff-Spritzgussteils besteht darin, dass das LCP und das sPS aufgrund der hohen Selektivität dieser Kunststoff-Kombination in Form von sehr dünnen, nebeneinander angeordneten Bahnen auf der Oberfläche des Kunststoff-Spritzgussteils hergestellt werden können. Bei herkömmlichen Kunststoff-Spritzgussteilen aus zwei unterschiedlichen LCP-Typen sind beispielsweise minimale Breiten von 250µm der Bahnen verwendbar, da schmälere Bahnen bei der Metallisierung einer Komponente nicht mehr formgetreu beschichtet werden können. Es ergeben sich Überlappungen der Metallisierungsschichten über die angrenzende Komponente, die nicht beschichtet werden soll, und damit im schlimmsten Fall Kurzschlüsse zwischen Bahnen. Dagegen sind bei der Kombination von sPS und LCP Bahnen mit einer Breite von jeweils nur etwa 200µm verwendbar. Im Hinblick auf die Forderung nach einer weitgehenden Miniaturisierung solcher Kunststoff-Spritzgussteile beziehungsweise der Bahnen ergibt sich hier also eine vorteilhafte Verringerung der Breiten um etwa 20% bei formgetreuer Beschichtung des LCP.
Besonders gut metallisierbar ist ein LCP, das ≥ 20ppm bis ≤ 500ppm Palladium als Katalysator enthält. Gut eignen sich auch faserverstärkte LCP-Typen oder solche mit mineralischer Füllung. Als Faserverstärkung können beispielsweise Glasfasern oder auch Kohlenstoff-Fasern eingesetzt werden.
Die Oberfläche des Kunststoff-Spritzgussteils sollte vorzugsweise alkalisch gebeizt sein, um die Metallisierbarkeit und Selektivität des entsprechenden LCP-Typs für die Anlagerung einer Metallschicht herzustellen oder zu erhöhen. Wenn das Kunststoff-Spritzgussteil als Schaltungsträger verwendet werden soll, wird die Oberfläche des Kunststoff-Spritzgussteils in Bereichen des LCP metallisiert. Beim alkalischen Beizen, beispielsweise mit Natronlauge, wird das LCP oberflächlich aufgerauht und je nach Beizdauer und Beiztemperatur abgetragen, während das sPS nicht abgetragen oder aufgerauht wird, sondern eine hohe Kantentreue aufweist. Günstig ist dabei die Verwendung von 10 bis 15 normaler Natronlauge, eine Beiztemperatur im Bereich von 60 bis 90°C und eine Beizdauer von 5 bis 60 Minuten. So sind in den Bereichen des LCP durch das Beizen rauhe Flächen und/oder "Gräben" in der Oberfläche des Kunststoff-Spritzgussteiles erzeugbar, die scharfe Kanten aus sPS aufweisen. Das LCP kann nach dem Beizen hervorragend formgetreu, d.h. senkrecht zur LCP-Oberfläche, metallisiert werden, indem die rauhen Flächen beschichtet und/oder die Gräben ganz oder teilweise mit Metall gefüllt werden. Dabei werden die frisch gebeizten LCP-Oberflächen vorzugsweise zuerst chemisch beziehungsweise außenstromlos mit Metall beschichtet.

Dabei ist das LCP vorzugsweise außenstromlos mit Kupfer metallisiert. Auf dem Kupfer können dann weitere metallische Schichten oder Schichtfolgen, zum Beispiel aus Nickel, Gold oder Zinn, angeordnet sein. Diese Schichten oder Schichtfolgen können ebenfalls außenstromlos oder galvanisch abgeschieden werden.

Als besonders für eine Kombination geeignete thermoplastische Komponenten haben sich der LCP-Typ Vectra® E 820i Pd der Firma Ticona GmbH und das syndiotaktisches Polystyrol Xarec® C 132 der Firma Idemitsu Petrochemical Co erwiesen.

Eine erfindungsgemäße Verwendung von syndiotaktischem Polystyrol als eine erste thermoplastische Komponente und LCP als eine zweite thermoplastische Komponente für die Herstellung eines Kunststoff-Spritzgussteils, wobei mindestens auf einer Oberfläche des Kunststoff-Spritzgussteils Bereiche aus der ersten thermoplastischen Komponente neben Bereichen aus der zweiten thermoplastischen Komponente angeordnet sind, ist ideal. Insbesondere, wenn das Kunststoff-Spritzgussteil ein MID-Bauteil ist.

Das Beispiel 1 sowie die Figuren 1 bis 6 sollen die Erfindung beispielhaft erläutern.

### Beispiel 1:

Als erste thermoplastische Komponente wird ein LCP-Typ mit Palladium und Glasfaserverstärkung gewählt ( z.B. der Typ Vectra® E 820i Pd der Firma Ticona GmbH ). Als zweite thermoplastische Komponente wird ein syndiotaktisches Polystyrol sPS verwendet ( z.B. der Typ Xarec® C 132 der Firma Idemitsu Petrochemical Co ). Die beiden thermoplastischen Komponenten werden im Spritzgussverfahren in dreidimensionaler Weise verbunden. Das entstandene Kunststoff-Spritzgussteil ( siehe Fig. 1 und 2 ) wird nachfolgend in 12 normaler Natronlauge 20 min lang bei einer Beiztemperatur von 80°C gebeizt ( siehe Fig. 3 und 4 ) und anschließend in einem Kupferbad außenstromlos bei einer Temperatur von 52°C über 45 min mit Kupfer beschichtet ( siehe Fig. 5 und 6 ). Die Dicke der Kupferschicht kann je nach gewählter Beschichtungszeit verändert werden. Nachfolgend wird zur Veredelung galvanisch auf die Kupferschicht eine Nickelschicht und auf die Nickelschicht eine Goldschicht aufgebracht.

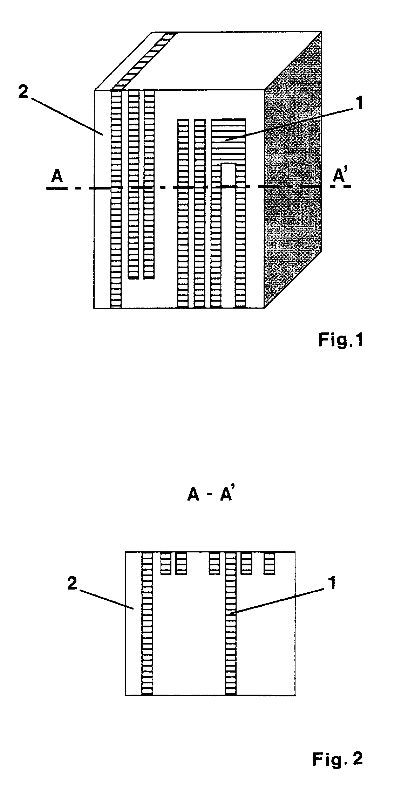

Fig. 1 zeigt eine dreidimensional Ansicht eines erfindungsgemäßen Kunststoff-Spritzgussteils nach Beispiel 1. Die erste thermoplastische Komponente 1 aus LCP ist in Form von dünnen Bahnen in der zweiten thermoplastischen Komponente 2 aus sPS integriert.

Fig. 2 zeigt einen Querschnitt A - A' durch das Kunststoff-Spritzgussteil aus Fig. 1.

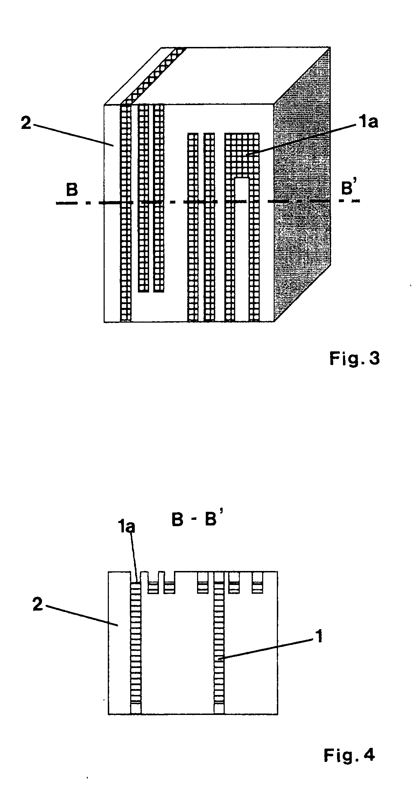

Fig. 3 zeigt das Kunststoff-Spritzgussteil aus Fig. 1 nach einer Behandlung mit 12 normaler Natronlauge. Die Oberfläche 1a der ersten thermoplastischen Komponente 1 wurde dabei aufgerauht und/oder unter Bildung von Gräben etwas abgetragen, während die Oberfläche und Gestalt der zweiten thermoplastischen Komponente 2 dabei nicht verändert wurde.

Fig. 4 zeigt einen Querschnitt B - B' durch das Kunststoff-Spritzgussteil aus Fig. 3, wobei eine Abtragung der ersten thermoplastischen Komponente 1 dargestellt ist.

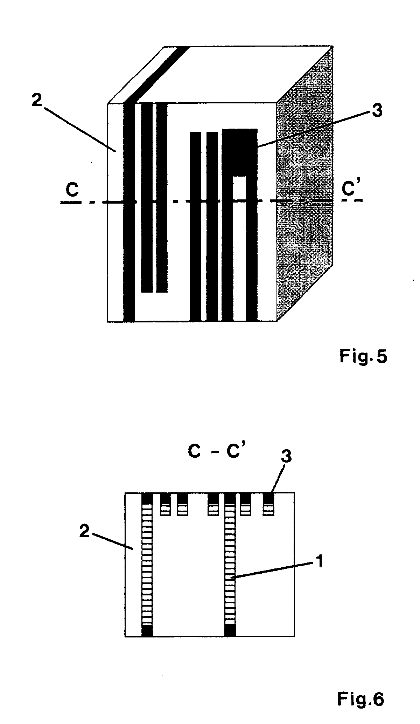

Fig. 5 zeigt das Kunststoff-Spritzgussteil aus Fig. 3 nach der Metallisierung. Die erste thermoplastische Komponente 1 wurde dabei oberflächlich metallisiert, während die Oberfläche der zweiten thermoplastischen Komponente 2 dabei nicht metallisiert wurde. Durch die Metallisierung sind leitende Bahnen 3 entstanden, die elektrisch angeschlossen werden können.

Fig. 6 zeigt einen Querschnitt C - C' durch das Kunststoff-Spritzgussteil aus Fig. 5, wobei das senkrecht zur Oberfläche der ersten thermoplastischen Komponente 1 abgeschiedene Metall in Gräben gemäß Fig. 4 erkennbar ist. Die Gräben können dabei beispielsweise auch nur teilweise gefüllt vorliegen.

## Patentansprüche

1. Kunststoff-Spritzgussteil bestehend aus einer ersten thermoplastischen Komponente und einer zweiten thermoplastischen Komponente, wobei mindestens auf einer Oberfläche des Kunststoff-Spritzgussteils Bereiche aus der ersten thermoplastischen Komponente neben Bereichen aus der zweiten thermoplastischen Komponente angeordnet sind, und wobei die erste thermoplastische Komponente ein LCP ist, **dadurch gekennzeichnet, dass** die zweite thermoplastische Komponente ein syndiotaktisches Polystyrol ist.

2. Kunststoff-Spritzgussteil nach Anspruch 1, **dadurch gekennzeichnet, dass** das LCP ≥ 20ppm bis ≤ 500ppm Palladium als Katalysator enthält.

3. Kunststoff-Spritzgussteil nach einem der Ansprüche 1 bis 2, **dadurch gekennzeichnet, dass** das LCP faserverstärkt ist.

4. Kunststoff-Spritzgussteil nach einem der Ansprüche 1 bis 2, **dadurch gekennzeichnet, dass** das LCP eine mineralische Füllung aufweist.

5. Kunststoff-Spritzgussteil nach einem der Ansprüche 1 bis 4, **dadurch gekennzeichnet, dass** die Oberfläche des Kunststoff-Spritzgussteils alkalisch gebeizt ist.

6. Kunststoff-Spritzgussteil nach einem der Ansprüche 1 bis 5, **dadurch gekennzeichnet, dass** die Oberfläche des Kunststoff-Spritzgussteils in Bereichen des LCP metallisiert ist.

7. Kunststoff-Spritzgussteil nach einem der Ansprüche 1 bis 5, **dadurch gekennzeichnet, dass** das LCP mit Kupfer metallisiert ist.

8. Kunststoff-Spritzgussteil nach Anspruch 7, **dadurch gekennzeichnet, dass** auf dem Kupfer weitere metallische Schichten angeordnet sind.

9. Verwendung von syndiotaktischem Polystyrol als eine erste thermoplastische Komponente und LCP als eine zweite thermoplastische Komponente für die Herstellung eines Kunststoff-Spritzgussteils, wobei mindestens auf einer Oberfläche des Kunststoff-Spritzgussteils Bereiche aus der ersten thermoplastischen Komponente neben Bereichen aus der zweiten thermoplastischen Komponente angeordnet sind.

10. Verwendung nach Anspruch 9, **dadurch gekennzeichnet, dass** das Kunststoff-Spritzgussteil ein MID-Bauteil ist.
